# FASCICULE DE BREVET EUROPEEN

(11) **EP 1 063 528 B1**
(45) Date de publication et mention de la délivrance du brevet: **29.09.2004**
(21) Numéro de dépôt: 00401690.3
(22) Date de dépôt: 15.06.2000
(51) Int. Cl.: G01R 29/10

(54) **Dispositif de mesure de caractéristiques d'un champ électromagnétique, notamment du diagramme de rayonnement d'une antenne**
Vorrichtung zur Messung von Charakteristiken eines elektromagnetischen Feldes, inbesondere für einen Antennestrahlungsdiagramm
Electromagnetic field measuring device, particularly for an antenna radiation pattern

(30) Priorité: 23.06.1999 FR 9908015
(43) Date de publication de la demande: 27.12.2000
(73) Titulaire: AGENCE SPATIALE EUROPEENNE, F-75738 Paris Cedex 15 (FR)
(72) Inventeur: Lemanczyk, Jerzy Michal, 2311 NV Leiden (NL); Jensen, Palle Frank, 2800 Lyngby (DK); Frandsen, Aksel B., 2920 Charlottenlund (DK)
(74) Mandataire: Jacquard, Philippe Jean-Luc

(56) Documents cités:
- PATENT ABSTRACTS OF JAPAN vol. 1999, no. 08, 30 juin 1999 (1999-06-30) & JP 11 074680 A (ANDO ELECTRIC CO LTD), 16 mars 1999 (1999-03-16)

## Description

L'invention concerne un dispositif de mesure de caractéristiques d'un champ électromagnétique rayonné par une source, notamment du diagramme de rayonnement d'une antenne émettant dans la gamme des hyperfréquences.

Pour fixer les idées, bien que l'invention ne puisse être limitée à cette seule application, on se placera dans ce qui suit dans le cadre de l'application préférée de l'invention, à savoir la mesure du diagramme de rayonnement d'une antenne, plus particulièrement d'une antenne utilisée dans la gamme des très hautes fréquences.

Les caractéristiques de rayonnement d'une antenne peuvent être déterminées en mesurant le champ de l'antenne sur une surface imaginaire traversée par la puissance rayonnée. Typiquement, cette surface de mesure est une surface plane, cylindrique ou sphérique. Naturellement, les mesures en question sont habituellement effectuées sur le site de l'utilisateur.

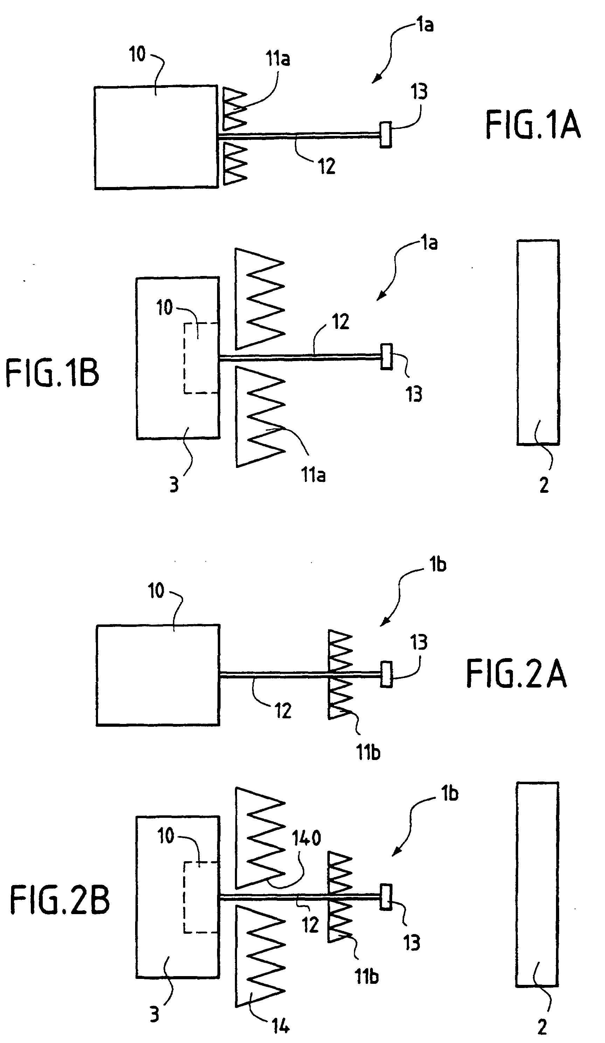

Le dispositif de mesure est généralement appelé sonde de mesure. La figure 1A placée, en fin de la présente description, illustre schématiquement un exemple de sonde de mesure selon l'art connu.

Une telle sonde de mesure la comprend essentiellement les composants suivants : un élément radiant 13 monté sur un support 12 et une monture de sonde 10. Cette monture 10 peut également constituer le support de divers circuits électroniques pour la conversion et le traitement des signaux reçus par la sonde 1. Le support 12 et l'élément radiant 13 constituent la sonde de mesure proprement dite.

L'élément radiant 13 peut prendre diverses configurations, selon l'application précise visée, la gamme de fréquences à mesurer, la polarisation des ondes émises par l'antenne en cours de test, etc. A titre d'exemples significatifs, l'élément radiant 13 peut être du type fente ou dipôle. On doit bien comprendre que le terme "radiant", s'applique indifféremment à l'émission ou à la réception d'ondes. Enfin, le support 12 de l'élément radiant 13 peut être fixé de façon définitive sur la monture 10 ou, au contraire, être démontable. L'organe de fixation comprend habituellement une plaque associée à un élément absorbant 11a, atténuant fortement le rayonnement reçu, dans la gamme de fréquences des mesures à effectuer.

Comme il est connu, la détermination de caractéristiques d'une antenne sous test, par exemple son diagramme de rayonnement, nécessite tout d'abord que la sonde de mesure soit elle-même parfaitement caractérisée. En effet, il est nécessaire de connaître non seulement un certain nombre de paramètres de mesure, mais aussi son comportement lorsqu'elle est plongée dans un champ électromagnétique. Même de faibles dimensions, la sonde de mesure n'est pas "neutre" vis-à-vis du champ électromagnétique à mesurer. Elle interagit avec celui-ci et peut le perturber.

La caractérisation de la sonde de mesure, appelée calibration, inclut la détermination du diagramme de rayonnement de la sonde, ses propriétés de polarisation, son gain, et le(s) coefficient(s) de réflexion d'entrée sur le(s) port(s) de la sonde.

Cette procédure est habituellement effectuée sur un site dit de calibration, différent de celui de l'utilisateur potentiel de la sonde de mesure. Il s'agit normalement d'un site de mesures de haute précision, où tous les paramètres entrant dans les mesures peuvent être maîtrisés. Toutes les caractéristiques de la sonde de mesure sont alors parfaitement définies par un jeu de données de calibration.

La sonde de mesure la peut ensuite être livrée, avec le jeu de données de calibration, à un utilisateur potentiel pour tester une antenne sur son site. Cependant, si les performances de la sonde de mesure, après montage sur site, diffèrent de celles déterminées lors de la calibration, alors la fiabilité des données de mesure de l'antenne en cours de test est sujette à caution.

La figure 1B illustre schématiquement la procédure de mesure des caractéristiques d'une antenne 2 sur le site de test. L'antenne sous test 2 est fixe et émet un rayonnement dont des caractéristiques déterminées doivent être mesurées. La sonde de mesure la, par contre, est mobile dans l'espace, sur une surface prédéterminée comme il a été indiqué (dans un plan par exemple). Pour ce faire, on monte la sonde de mesure la sur un dispositif porteur mobile 3, se déplaçant selon un trajet déterminé, de manière à balayer la surface précitée, avantageusement sous la commande de moyens informatisés. Les mesures effectuées en chaque point sont enregistrées ou traitées en temps réel.

Une source majeure de dérives entre les performances obtenues lors de la calibration et celles obtenues sur site de mesure, peut être trouvée dans les différences de montage de la sonde de mesure la entre le site de calibration et le site de mesure, respectivement. Il est donc nécessaire de trouver une solution, c'est-à-dire en pratique des moyens appropriés permettant d'éliminer l'influence nuisible du montage de la sonde de mesure 1a.

Sur le site de calibration (figure 1A), il est relativement simple d'éliminer, en grande partie, l'influence du montage de la sonde de mesure la, par un traitement numérique approprié des données de calibration. En effet, comme il a été indiqué, les caractéristiques du site de calibration sont parfaitement connues, répétitives et maîtrisées. Les caractéristiques des sources de calibration sont également bien connues.

Par contre, pour chaque site de mesure (figure 1B), les caractéristiques environnementales diffèrent. Par définition, les caractéristiques exactes de la source de rayonnement, c'est-à-dire de l'antenne 2 en cours de test, sont inconnues, puisqu'elles font précisément l'objet des mesures. Le montage de la sonde de mesure la est a priori différent de celui réalisé sur le site.

Une utilisation telle quelle du jeu de données de calibration n'est donc pas possible si les exigences de précision de mesures sont élevées.

Dans l'art connu, on a proposé diverses solutions pour tenter de résoudre ce problème. Les figures 2A et 2B illustrent une des solutions ainsi proposées. Les éléments communs avec ceux des figures précédentes portent les mêmes références et ils ne seront re-décrits qu'en tant que de besoin.

Cette solution a été décrite dans les documents suivants, auxquels on se reportera avec profit pour plus de détails :
- l'article de Franck JENSEN et de J. LEMANCZYK, intitulé : " Accurate gain measurements on small aperture antennas", paru dans "Proceedings of 14 ^{th} ESA Workshop on Antenna Measurements", WWP-028, 6-8 mai 1991 ; et
- l'article de Franck JENSEN et de J. LEMANCZYK, intitulé : "The calibration probes for near-field measurements", "AMTA Symposium", pages 9.5-9.10, 7-11 octobre 1991.

La structure de la sonde de mesure, désormais référencée 1b, diffère de celle de la sonde de mesure 1a des figures 1A et 1B, essentiellement par le fait qu'un élément absorbant, référencé 11b, fait partie intégrante de la sonde de mesure proprement dite. De façon plus précise, comme illustré plus particulièrement par la figure 2A, l'élément absorbant 11b est directement assujetti au support 12, en arrière de l'élément radiant 13.

Sur le site de mesure, comme illustré par la figure 2B, on prévoit un élément absorbant supplémentaire fixe 14, muni d'une fente 140 autorisant le déplacement de la sonde de mesure 1b sur le dispositif porteur mobile 3.

Cette solution est cependant considérée comme un pis-aller. En effet, les éléments absorbants sont réalisés à base de matériaux légers et fragiles. Il est donc difficile de garantir une bonne reproductibilité et de maintenir une forme stable, d'un point de vue des propriétés électriques.

L'invention vise à pallier les inconvénients des dispositifs de l'art connu, et dont certains viennent d'être rappelés.

Pour ce faire, selon une caractéristique principale de l'invention, en lieu et place d'un élément absorbant l'énergie rayonnée vers la monture de la sonde de mesure, on prévoit des moyens pour ré-émettre le rayonnement de façon contrôlée.

Ceci est obtenu en utilisant un écran réalisé à base d'un matériau réfléchissant l'énergie incidente, dans la gamme des longueurs d'onde à mesurer, et la ré-émettant.

Selon une autre caractéristique de l'invention, la forme de l'écran précité est optimisée de manière à redistribuer l'énergie rayonnée par celui-ci selon des directions angulaires de grande amplitude, directions pour lesquelles les nuisances sont peu importantes.

Généralement, le site de mesure comprend une chambre anéchoïde dans laquelle l'antenne à tester est placée. Les parois de cette chambre sont à base de matériau absorbant les ondes électromagnétiques dans la gamme des fréquences émises par l'antenne. Les angles de ré-émission de l'écran peuvent être déterminés de façon à ce que le rayonnement ré-émis soit dirigé vers les parois de cette chambre anéchoïde, pour y être absorbé.

L'invention présente donc de nombreux avantages, parmi lesquels :
- la monture de sonde de mesure n'est plus illuminée, puisque protégée par l'écran, et elle n'a donc pas d'influence sur les caractéristiques de la sonde de mesure ;
- la monture de la sonde de mesure n'a pas d'impact sur les courants qui se développent sur le support de la sonde de mesure ;
- la construction de la sonde de mesure est robuste et reste stable dans des conditions normales d'utilisation ;
- l'écran peut être déterminé de façon très précise, de manière à obtenir des performances optimales en ce qui concerne la diffusion dans l'espace du rayonnement, les dimensions géométriques et le poids, ce en utilisant avantageusement des logiciels éprouvés et validés ;
- les courants dans le support de sonde de mesure sont contrôlés déjà au stade de la conception, par exemple en ajoutant des selfs ou en adoptant des mesures similaires ;
- l'écran peut être utilisé pour tous types d'éléments radiants : dipôle, guide d'onde ouvert en cornet, etc. ;
- une interface bien définie et distincte existe entre la sonde de mesure proprement dite et sa monture : les dimensions des parties radiantes, par exemple l'élément radiant, son support et l'écran, sont bien définies, et l'expansion du rayonnement de sonde en mode spectre comprend un nombre fini de modes ;
- l'écran peut être conçu pour modifier faiblement les caractéristiques de la sonde de mesure lorsque la fréquence varie, de sorte que la calibration ne nécessite pas d'être effectuée avec des incréments de fréquence très fins ;
- la conception et la réalisation d'une telle sonde de mesure restent entièrement compatibles avec les technologies propres au domaine et elles ne se traduisent pas par une augmentation de la complexité et/ou un surcoût significatifs.

L'invention a donc pour objet principal un dispositif de mesure de caractéristiques d'un champ électromagnétique émis par une source, dite sous test, le dispositif comprenant un élément radiant, un support de cet élément radiant et une monture à laquelle est assujetti ledit support, caractérisé en ce qu'il comprend un écran porté par ledit support, interposé entre ledit élément radiant et ladite monture, et en ce que ledit écran réfléchit les rayons du champ électromagnétique qui le frappent, de manière à les réémettre et les disperser dans l'espace, de façon à ce que les rayons réfléchis ne frappent pas la source sous test.

L'invention va maintenant être décrite de façon plus détaillée en se référant aux dessins annexés, parmi lesquels :
- les figures 1A et 1B illustrent schématiquement un premier exemple de sonde de mesure de caractéristiques d'un champ électromagnétique, lors d'une phase de calibration et d'une phase de mesure proprement dites ;
- les figures 2A et 2B illustrent schématiquement un second exemple de sonde de mesure de caractéristiques d'un champ électromagnétique, lors d'une phase de calibration et d'une phase de mesure proprement dites ;
- la figure 3 illustre schématiquement une structure de sonde de mesure conforme à l'invention ;
- la figure 4 illustre un exemple de réalisation pratique d'une sonde de mesure conforme à l'invention ;
- la figure 5A est un diagramme représentant la variation de l'amplitude du signal mesuré en fonction de l'angle d'incidence d'une onde électromagnétique émise par une source ;
- les figures 5B et 5C sont des portions agrandies du diagramme de la figure 5A ;
- la figure 6A est un diagramme montrant les dégradations du diagramme de rayonnement de la sonde résultant du retrait de l'écran, composant caractéristique principal selon l'invention ;
- la figure 6B est une portion agrandie du diagramme de la figure 5A ; et
- la figure 7 est un diagramme illustrant la directivité de la sonde de mesure en fonction de la fréquence, avec et sans écran.

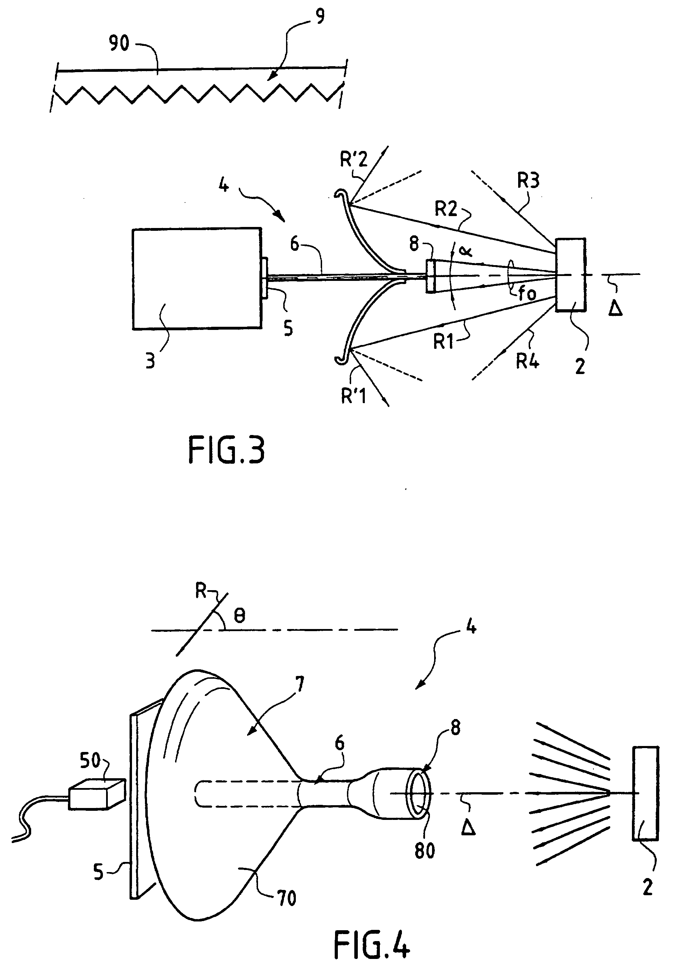

La figure 3 illustre schématiquement un exemple de réalisation d'une sonde de mesure selon l'invention, désormais référencée 4.

Celle-ci comprend, comme dans l'art connu, un élément radiant 8 porté par un support 6 (longiforme dans l'exemple décrit), lui-même assujetti, de façon fixe ou non, à une monture 5.

Si la sonde de mesure 4 est sur site de mesure, elle est disposée sur un dispositif porteur mobile 3, et elle reçoit le rayonnement électromagnétique émis par l'antenne sous test 2.

Comme il a été indiqué, l'ensemble de ces composants est généralement disposé dans une chambre anéchoide 9, dont les parois (représentées partiellement sur la figure 3) sont réalisées à base de matériau absorbant substantiellement les ondes émises par l'antenne 2.

Selon la caractéristique principale de l'invention, le support 8 est muni d'un écran 7. Cet écran 7 est réalisé en un matériau réfléchissant le rayonnement capté, et conformé de telle sorte à ré-émettre le rayonnement suivant des directions angulaires telles que les rayons ré-émis, pour l'essentiel, ne frappent pas l'antenne 2 et sont dirigés vers les parois absorbantes 90 de la chambre anéchoïde 9, dans lesquelles ils sont absorbés.

Une deuxième fonction de l'écran 7 est de "protéger" le support 6, la monture 5 et le dispositif porteur mobile 3, vis-à-vis du rayonnement émis par l'antenne 2, c'est-à-dire de jouer une fonction d'écran proprement dite.

Le mode de fonctionnement suivant l'invention est illustré de façon schématique par la figure 3. Seul un mince faisceau central f₀, centré sur l'axe de symétrie Δ de la sonde de mesure 4, ou axe de visée, est capté par l'élément radiant 8 de la sonde de mesure 4. En dehors du faisceau central f₀, des rayons émis par l'antenne 2, R₁ et R₂, situés angulairement de part et d'autre de l'axe de visée Δ mais insuffisamment divergents pour pouvoir être interceptés par la surface de l'écran 7, sont réfléchis par celui-ci et ré-émis (références R'₁ et R'₂) vers les parois 90 de la chambre anéchoïde 9. Des rayons extrêmes du faisceau émis par l'antenne 2, par exemple les rayons R₃ et R₄ sur la figure, situés de part et d'autre de l'axe de visée Δ, ne sont captés ni par l'élément rayonnant 8, ni par l'écran 7, de sorte qu'ils frappent directement les parois 90 de la chambre anéchoïde 9.

On va maintenant décrire un exemple de réalisation pratique d'une sonde de mesure 4 selon l'invention. Un tel exemple de réalisation est représenté en perspective sur la figure 4. Les éléments communs avec ceux des figures précédentes portent les mêmes références et ils ne seront re-décrits qu'en cas de besoin.

Dans l'exemple décrit, l'élément radiant 8 est un cornet conique ouvert recevant le rayonnement de l'antenne 2, suivant une direction centrée sur l'axe de visée Δ. Le support 6 est un guide d'onde de section circulaire, d'axe de symétrie confondu avec l'axe Δ. L'écran 7 a la forme d'une jupe métallique conique, de section circulaire, concentrique à l'axe Δ. L'angle au sommet du cône est un angle aigu tourné vers la monture 5.

La monture 5 est constituée essentiellement d'une plaque métallique rectangulaire, par exemple en acier traité, sur laquelle le support 6 est enfiché. Le plan de la plaque 5 est sensiblement orthogonal à l'axe Δ. Celle-ci supporte, sur sa partie arrière, des circuits électroniques 50, sensibles aux ondes transmises par le support guide d'onde 6, et formant interface avec des circuits classiques de traitement de signal (non représentés). Naturellement, on prévoit un orifice de communication (non représenté) entre la sortie du guide d'onde 6 et les circuits électroniques 50.

On constate aisément que, du fait de la forme enveloppante de l'écran 7, seul un rayonnement R, de fort angle d'incidence θ par rapport à l'axe Δ, peut atteindre l'extrémité du support 6 (côté monture 5) et/ou la monture 5. Comme illustré précédemment par la figure 3, les autres rayons sont, soit captés par l'ouverture 80 du cornet 8, soit frappent la surface externe 70 de la jupe formant l'écran 7 et sont ré-émis suivant des directions formant un angle important avec l'axe Δ.

Pour fixer les idées, les principales dimensions du dispositif de mesure 4 illustré par la figure 4 sont les suivantes :
- diamètre de jupe formant l'écran 7 (ouverture tournée vers l'antenne) : 268 mm ;
- angle d'ouverture de la jupe (vers l'arrière) par rapport à l'axe Δ : 45° ;
- épaisseur de la paroi de la jupe : 4,0 mm ;
- longueur cumulée du support 6 (en avant de la jupe) et du cornet 8 : 216,8 mm ;
- longueur totale du support 6 : 555 mm ;
- longueur du cornet 8 : 171,81 mm avec un méplat avant de 15,6 mm ;
- diamètre extérieur du cornet 8 : 49,0 mm et intérieur : 46,6 mm ;
- angle d'ouverture du cornet : 14,0° par rapport à l'axe Δ ;
- diamètre extérieur du guide d'onde : 20,9 mm et intérieur : 10,9 mm ;

Pour illustrer de façon plus complète les caractéristiques avantageuses de l'invention, il a été procédé à une analyse numérique du comportement de la sonde de mesure 4 selon l'invention, illuminée par un rayonnement d'incidence variable, dans différentes configurations : avec l'écran 7, sans l'écran 7, et sans l'écran 7, ni la plaque arrière (monture) 5.

Pour ce faire, on a rendu fixe la sonde de mesure 4 et illuminé celle-ci par une source étalon en champ lointain, et l'on a relevé l'amplitude du signal mesuré en fonction de l'angle d'incidence des rayons, par rapport à l'axe Δ. La fréquence émise par la source étalon était de 27,75 GHz.

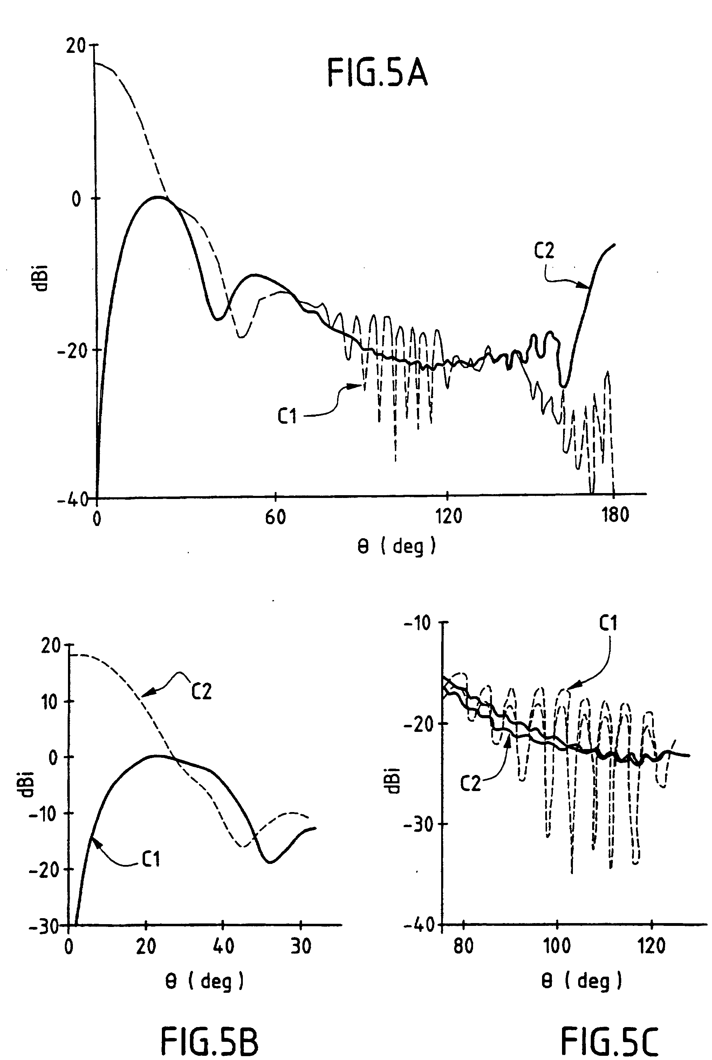

La figure 5A est un diagramme représentant la variation de l'amplitude (en dBi) du signal mesuré pour des angles d'incidence θ variant de 0 à 180 degrés, avec écran 7, et sans écran 7 et plaque arrière 5, respectivement. De façon plus précise, le diagramme de la figure 5A représente deux jeux de courbes (les diagrammes de rayonnement en co-polarisation et en polarisation croisée à 45 degrés) : C₁ pour une sonde de mesure 4 selon l'invention, comprenant un écran 7 (et une plaque arrière 5)et C₂ lorsque l'on retire ces deux composants.

On constate à l'étude de ces courbes que le diagramme de rayonnement de la sonde de mesure 4 est peu perturbé par la présence de l'écran 7 pour, approximativement, les valeurs de l'angle θ comprises entre 80 et 120 degrés. Pour des angles θ plus importants, son impact est plus prononcé.

Ceci est conforme aux buts de l'invention de rediriger l'énergie vers des zones situées en dehors du champ de vision (vu de la sonde de mesure) de l'antenne en cours de test.

Les figures 5B et 5C sont des portions agrandies de la figure 5A, pour les gammes d'angles θ allant de 0 degré à 60 degrés et de 75 à 125 degrés, respectivement.

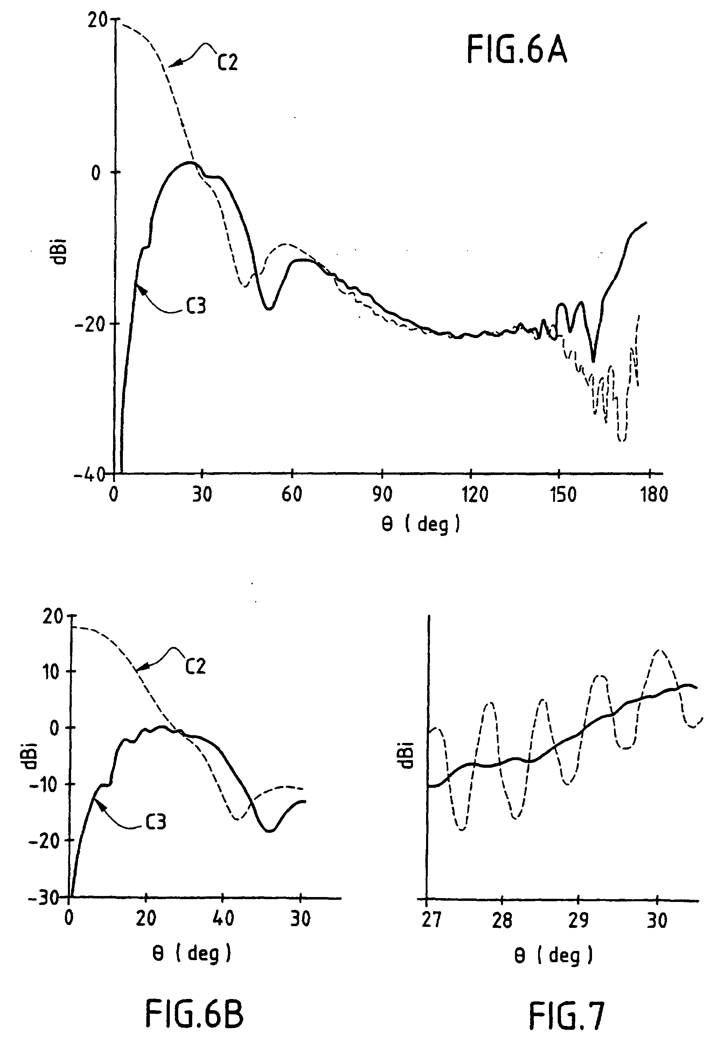

La figure 6A montre les dégradations du diagramme de rayonnement résultant du retrait de l'écran 7 et de l'illumination directe de la monture 5 : jeux de courbes C₃. On a reporté sur ce diagramme, à titre de comparaison, le jeu de courbes C₂ (ni écran 7, ni plaque arrière 5). L'influence du rayonnement à faible incidence est très forte, même sur la forme du faisceau principal de co-polarisation.

La figure 6B est une portion agrandie de la figure 6A pour les gammes d'angles θ allant de 0 degré à 60 degrés.

La figure 7 est un diagramme illustrant la variation de la directivité de la sonde de mesure 4 en fonction de la fréquence du rayonnement capté, pour deux configurations : avec l'écran 7 (courbe C₄) et sans l'écran 7 mais avec la plaque arrière 5 (courbe C₅). La gamme de fréquence balayée va de 26 à 31 GHz. La directivité est exprimée en dBi.

On constate de fortes oscillations lorsque seule la plaque arrière 5 est présente (courbe C₅). Ces oscillations sont très atténuées lorsque l'écran 7 est présent. Il s'ensuit des variations en fréquence beaucoup plus douces, ce qui constitue un des avantages de l'invention. Comme il a été indiqué, la calibration de la sonde de mesure 4 ne nécessite plus de fins incréments de fréquence.

A la lecture de ce qui précède, on constate aisément que l'invention atteint bien les buts qu'elle s'est fixés.

Elle présente en effet de nombreux avantages. Sans répéter tous ceux qui ont été énoncés dans le préambule de la présente description, de par les dispositions propres à l'invention, notamment la monture de la sonde de mesure n'étant plus illuminée, celle-ci n'a plus d'influence sur les caractéristiques de la sonde de mesure. Ces dernières ne sont plus dépendantes non plus de la façon précise dont la sonde est montée sur le site de mesure. La construction de la sonde de mesure est robuste et son fonctionnement reste stable dans des conditions normales d'utilisation. Sa construction et les composants utilisés restent compatibles avec les technologies couramment mises en oeuvre pour ce type d'application. Les dispositions spécifiques à l'invention ne conduisent pas à un surcoût sensible, ni n'induisent une plus grande complexité. Elles permettent, de surcroît, de simplifier la procédure de calibration, en diminuant le nombre nécessaire de points de mesure en fonction de la fréquence.

Il doit être clair cependant que l'invention n'est pas limitée aux seuls exemples de réalisations qui ont été explicitement décrits, notamment en relation avec les figures 3 à 7. En particulier, les valeurs numériques n'ont été précisées que pour fixer les idées. Elles dépendent essentiellement de l'application précise visée, notamment de la fréquence émise par l'antenne à tester. Il en est de même des matériaux utilisés.

## Revendications

1. Dispositif de mesure des caractéristiques d'un champ électromagnétique émis par une source sous test, comprenant un élément radiant, un support de cet élément radiant et une monture à laquelle est assujetti ledit support, **caractérisé en ce qu'**il comprend un écran (7) porté par ledit support (6), interposé entre ledit élément radiant (8) et ladite monture (5), et **en ce que** ledit écran (7) est propre à réfléchir les rayons (R₁, R₂) du champ électromagnétique qui le frappent de manière à les ré-émettre dispersés dans l'espace de façon à ce que les rayons réfléchis ne frappent pas la source sous test.

2. Dispositif de mesure selon la revendication 1, **caractérisé en ce que**, ledit élément radiant (8) étant associé à un axe de visée (Δ) servant à pointer le dispositif de mesure (4) suivant des directions de mesure déterminées, ledit écran (7) est doté d'une forme telle que lesdits rayons ré-émis (R'₁, R'₂) sont dirigés suivant des angles de grandes amplitudes s'écartant dudit axe de visée (Δ).

3. Dispositif de mesure selon la revendication 1 ou 2, **caractérisé en ce que**, ladite source de rayonnement électromagnétique sous test (2) étant disposée sur un site de mesure comprenant une chambre anéchoïde (9), dont les parois (90) sont à base de matériau absorbant les longueurs d'onde associées audit rayonnement et à l'intérieur de laquelle ladite source (2) est placée, ledit écran (7) présente une forme qui est déterminée de manière que lesdits rayons ré-émis (R'₁, R'₂) le soient vers lesdites parois absorbantes (90) quand ledit dispositif est utilisé en sonde (4) de mesure des caractéristiques de ladite source sous test.

4. Dispositif selon l'une quelconque des revendications 1 à 3, **caractérisé en ce qu'**il est associé à un dispositif porteur mobile (3) pour l'entraîner à balayer une surface prédéterminée quand il est utilisé en sonde de mesure (4) pour ladite source de rayonnement sous test (2), celle-ci étant fixe.

5. Dispositif de mesure selon la revendication 4, **caractérisé en ce que** ladite surface prédéterminée est plane.

6. Dispositif de mesure selon la revendication 4, **caractérisé en ce que** ladite surface prédéterminée est cylindrique.

7. Dispositif de mesure selon l'une quelconque des revendications précédentes, **caractérisé en ce que** ledit élément radiant est un cornet conique (8), ledit support est un guide d'onde (6), de section circulaire, prolongeant ledit cornet conique (8) sur un axe de symétrie confondu avec un axe de visée (Δ), et ladite monture est une plaque rectangulaire (5).

8. Dispositif de mesure selon la revendication 7, **caractérisé en ce que** ledit écran est une jupe conique (7), de section circulaire, concentrique audit axe de visée (Δ) et tournée vers ladite monture (5) suivant un angle aigu avec ledit axe de visée (Δ), notamment un angle de l'ordre de 45 degrés.

9. Dispositif de mesure selon l'une quelconque des revendications 7 à 8, **caractérisé en ce que** lesdits éléments radiants (8), support (6), monture (5) et écran (7) sont métalliques.

10. Dispositif de mesure selon l'une quelconque des revendications précédentes, **caractérisé en ce que** ladite source est une antenne (2) émettant dans la gamme des hyperfréquences et **en ce que** lesdites caractéristiques à mesurer sont celles du diagramme de rayonnement de ladite antenne (2).

## Claims

1. Device for measuring the characteristics of an electromagnetic field emitted by a source under test, comprising a radiant element, a support for this radiant element and a mount to which the said support is fixed, **characterised in that** it comprises a screen (7) carried by the said support (6), interposed between the said radiant element (8) and the said mount (5), and **in that** the said screen (7) is able to reflect the electromagnetic-field rays (R₁, R₂) which strike it so as to re-emit them scattered in space so that the reflected rays do not strike the source under test.

2. Measuring device according to Claim 1, **characterised in that**, the said radiant element (8) being associated with an axis of sight (Δ) serving to aim the measuring device (4) in given measuring directions, the said screen (7) is provided with a shape such that the re-emitted rays (R'₁, R'₂) are directed at angles of great magnitude moving away from the said axis of sight (Δ).

3. Measuring device according to Claim 1 or 2, **characterised in that**, the said source of electromagnetic radiation under test (2) being disposed on a measuring site comprising an anechoic chamber (9), the walls (90) of which are based on material absorbing the wavelengths associated with the said radiation and inside which the said source (2) is placed, the said screen (7) has a form which is determined so that the said re-emitted rays (R'₁, R'₂) are re-emitted towards the said absorbent walls (90) when the said device is used as a sensor (4) measuring the characteristics of the said source under test.

4. Device according to any one of Claims 1 to 3, **characterised in that** it is associated with a movable carrying device (3) for driving it to sweep a predetermined surface when it is used as a measuring sensor (4) for the said source of radiation under test (2), the latter being fixed.

5. Measuring device according to Claim 4, **characterised in that** the said predetermined surface is planar.

6. Measuring device according to Claim 4, **characterised in that** the said predetermined surface is cylindrical.

7. Measuring device according to any one of the preceding claims, **characterised in that** the said radiant element is a conical horn (8), the said support is a waveguide (6), with a circular cross-section, extending the said conical horn (8) on an axis of symmetry merged with an axis of sight (Δ), and the said mount is a rectangular plate (5).

8. Measuring device according to Claim 7, **characterised in that** the said screen is a conical skirt (7), with a circular cross-section, concentric with the said axis of sight (Δ) and turned towards the said mount (5) at an acute angle to the said axis of sight (Δ), in particular an angle of around 45°.

9. Measuring device according to either one of Claims 7 to 8, **characterised in that** the said radiant elements (8), support (6), mount (5) and screen (7) are metallic.

10. Measuring device according to any one of the preceding claims, **characterised in that** the said source is an antenna (2) emitting in the microwave range and **in that** the said characteristics to be measured are those of the radiation diagram of the said antenna (2).

## Patentansprüche

1. Vorrichtung zur Messung der Charakteristiken eines von einer im Test befindlichen Quelle ausgestrahlten elektromagnetischen Feldes mit einem abstrahlenden Element, einem Träger für dieses abstrahlende Element und einer Fassung, an welcher der genannte Träger befestigt ist, **dadurch gekennzeichnet, dass** sie einen Schirm (7) aufweist, welcher vom genannten Träger (6) getragen wird und zwischen dem genannten abstrahlenden Element (8) und der genannten Fassung (5) angeordnet ist, und dass der genannte Schirm (7) geeignet ist, die auf ihn fallenden Strahlen (R₁, R₂) des elektromagnetischen Feldes derart zu reflektieren, dass sie derart räumlich gestreut wieder abgestrahlt werden, dass die reflektierten Strahlen nicht auf die im Test befindliche Quelle fallen.

2. Messvorrichtung nach Anspruch 1, **dadurch gekennzeichnet, dass** bei Zuordnung des genannten abstrahlenden Elements (8) zu einer zur Ausrichtung der Messvorrichtung (4) in bestimmte Messrichtungen dienenden Peilachse (Δ) der genannte Schirm (7) eine derartige Form aufweist, dass die wieder abgestrahlten Strahlen (R'₁, R'₂) an von der genannten Peilachse (Δ) ausgehenden, eine große Winkelamplitude aufweisenden Winkeln ausgerichtet sind.

3. Messvorrichtung nach Anspruch 1 oder 2, **dadurch gekennzeichnet, dass** bei Anordnung der genannten, im Test befindlichen elektromagnetischen Strahlungsquelle (2) an einem Mess-Standort mit einer reflexionsfreien Kammer (9), deren Wände (90) aus einem die der genannten Strahlung zugeordneten Wellenlängen absorbierenden Material bestehen und innerhalb welcher die genannte Quelle (2) eingesetzt ist, der genannte Schirm (7) eine derart festgelegte Form aufweist, dass die wieder abgestrahlten Strahlen (R'₁, R'₂) in Richtung der genannten absorbierenden Wände (90) wieder abgestrahlt werden, wenn die genannte Vorrichtung als Sensor (4) zur Messung der Charakteristiken der genannten, im Test befindlichen Quelle verwendet wird.

4. Messvorrichtung nach einem beliebigen der Ansprüche 1 bis 3, **dadurch gekennzeichnet, dass** sie einer beweglichen Tragvorrichtung (3) zugeordnet ist, von welcher sie mitgenommen wird, um eine bestimmte Oberfläche abzutasten, wenn sie als Mess-Sensor (4) für die genannte, im Test befindliche Strahlungsquelle (2) verwendet wird, wobei diese ortsfest ist.

5. Messvorrichtung nach Anspruch 4, **dadurch gekennzeichnet, dass** die genannte vorbestimmte Oberfläche eben ist.

6. Messvorrichtung nach Anspruch 4, **dadurch gekennzeichnet, dass** die genannte vorgegebene Fläche zylindrisch ist.

7. Messvorrichtung nach einem der vorangehenden Ansprüche, **dadurch gekennzeichnet, dass** das abstrahlende Element ein Konushom (8) ist, der genannte Träger ein Wellenleiter (6) mit kreisförmigem Querschnitt ist, welcher das genannte Konushorn (8) auf einer mit einer Peilachse (Δ) übereinstimmenden Symmetrieachse verlängert, und die genannte Fassung eine rechteckige Platte (5) ist.

8. Messvorrichtung nach Anspruch 7, **dadurch gekennzeichnet, dass** der genannte Schirm ein kegelförmiger Mantel (7) mit kreisförmigem Querschnitt ist, welcher zur Peilachse (Δ) konzentrisch verläuft und der genannten Fassung (5) unter Bildung eines spitzen Winkels mit der genannten Peilachse (Δ), insbesondere eines Winkels in der Größenordnung von 45°, zugewandt ist.

9. Messvorrichtung nach einem beliebigen der Ansprüche 7 bis 8, **dadurch gekennzeichnet, dass** die genannten abstrahlenden Elemente (8), der Träger (6), die Fassung (5) und der Schirm (7) metallisch sind.

10. Messvorrichtung nach einem der vorangehenden Ansprüche, **dadurch gekennzeichnet, dass** die genannte Quelle eine Antenne (2) ist, welche im Mikrowellenbereich sendet, und dass die genannten zu messenden Charakteristiken diejenigen des Strahlungsdiagramms der genannten Antenne (2) sind.
